# EUROPÄISCHE PATENTSCHRIFT

(11) **EP 2 709 786 B1**
(45) Veröffentlichungstag und Bekanntmachung des Hinweises auf die Patenterteilung: **29.03.2017**
(21) Anmeldenummer: 12720889.0
(22) Anmeldetag: 15.05.2012
(51) Int. Cl.: B23K 1/00, B23K 1/06

(54) **VERFARHEN ZUM STOFFSCHLÜSSIGEN VERBINDEN VON ELEMENTEN**
METHOD FOR THE COHESIVE CONNECTION OF ELEMENTS
PROCÉDÉ POUR RELIER DES ÉLÉMENTS PAR LIAISON DE MATIÈRE

(30) Priorität: 17.05.2011 DE 102011050436; 10.06.2011 DE 102011051024
(43) Veröffentlichungstag der Anmeldung: 26.03.2014
(73) Patentinhaber: Fraunhofer-Gesellschaft zur Förderung der angewandten Forschung e.V., 80686 München (DE)
(72) Erfinder: MEYER, Stefan, 63549 Ronneburg (DE); VON CAMPE, Hilmar, 61352 Bad Homburg (DE); HUBER, Stephan, 83562 Rechtmehring (DE); BÖHME, Sven, 09600 Niederschöna (DE)
(86) Internationale Anmeldenummer: PCT/EP2012/059039
(87) Internationale Veröffentlichungsnummer: WO 2012/156412

(56) Entgegenhaltungen:
- EP-A1- 2 289 658
- DE-A1- 2 236 699
- DE-A1-102006 035 626

## Beschreibung

Die Erfindung bezieht sich auf ein Verfahren zum stoffschlüssigen Verbinden eines ersten Elements, wie ersten Verbinder, mit einem zweiten Element, wie zweiten Verbinder und/oder Halbleiterbauelement wie Solarzelle, wobei die Elemente während des Verbindens aufeinander liegen und mittels Lotmaterial verbunden werden, das während des Verbindens mittels eines Werkzeugs, wie Sonotrode, mit Ultraschallschwingungen beaufschlagt wird, wobei das Werkzeug während des Verbindens eine Temperatur T_{W} mit insbesondere T_{W} ≥ T_{S} mit T_{S} = Schmelztemperatur des Lotmaterials aufweist.

Aus der WO-A-2008/014900 (DE-A-10 2006 035 626) ist ein Verfahren zum Anbringen eines Verbindungsleiters an einer Solarzelle bekannt, bei dem ein Lot mittels Ultraschalllötens auf die Solarzelle aufgebracht wird. Hierzu wird das Lot in Form eines Lotdrahts oder von Lotformteilen mittels einer Ultraschallsonotrode bei Löttemperatur aufgelötet.

Das Auflöten von Lot auf insbesondere Solarzellen mittels Ultraschall zeigt den Vorteil, dass ein Flussmittel nicht benutzt werden muss, wodurch anderenfalls die Gefahr einer Beschädigung der Solarzelle erwächst. Auch ergibt sich der Vorteil, dass die anschließende Laminationszeit in der Modulproduktion verkürzt werden kann.

Bei der Verwendung von Flussmitteln ist des Weiteren nachteilig, dass Verschmutzungen von Produktionsanlagen auftreten oder gesundheitsschädliche Dämpfe entstehen können.

Durch die Ultraschalleinwirkung werden auf den Solarzellen vorhandene Oxidschichten aufgebrochen, um eine mechanisch feste und elektrisch gut leitende Verbindung zwischen dem Lot und der entsprechenden Metallschicht der Solarzelle sicherzustellen. Dies ist insbesondere dann von Vorteil, wenn es sich bei der Metallschicht um eine Aluminiumschicht wie ein aus Aluminium bestehender Rückseitenkontakt handelt.

Entsprechende Ultraschalllötverfahren sind z. B. auch der US-B-6,357,649 oder der Literaturstelle Mardesich et al.: "A Low-Cost Photovoltaic Cell Process Based on Thick Film Techniques"; 14th IEEE PV, Sp.Conf. Proc., 1980, Seiten 943 - 947, zu entnehmen.

Ein Verfahren und eine Vorrichtung zum Verlöten von Verbindungsleitern mit einer Solarzelle sind aus der EP-A 2 289 658 bekannt. Dabei werden Anschlusskontakte und eine Solarzelle in einer Stapelanordnung aufeinanderliegend angeordnet, die Stapelanordnung homogen erhitzt und an die Anschlusskontakte eine Ultraschallschwingungen applizierende Sonotrode aufgesetzt. Dabei sind die Verbindungsleiter auf ihrer Ober- und Unterseite mit einem Lot beschichtet. Die entsprechende Stapelanordnung wird sodann auf eine Heizeinrichtung gelegt, von der die erforderliche Wärme auf die Stapelanordnung übertragen wird. Hierdurch wird Energie zum flussmittelfreien Verlöten zugeführt.

Die DE-A-22 36 699 bezieht sich auf ein flussmittelfreies Verbinden von Teilen. Hierzu wird ein Lötkolben benutzt, der mit einer Frequenz kleiner als 1000 Hz in Schwingung versetzt wird.

Die DE-A-41 04 160 beschreibt das Verbinden von Solarzellenkontaktelementen, die eine Relativbewegung zwischen den Zellen ermöglichen.

Der US-A-2005/0217718 ist ein Verfahren zum Verbinden von Solarzellen zu einem Modul zu entnehmen. Um zwei Solarzellen über einen Verbinder zu verschalten, kann dieser eine Öffnung einer der Solarzellen durchsetzen, um sodann neben der Öffnung z.B. mittels Ultraschall oder durch Lasern mit der Solarzelle stoffschlüssig verbunden zu werden.

Der vorliegenden Erfindung liegt die Aufgabe zugrunde, ein Verfahren der eingangs genannten Art so weiterzubilden, dass energetisch günstig ein stoffschlüssiges Verbinden erfolgen kann. Gleichzeitig soll die Möglichkeit bestehen, gezielt das Lotmaterial in die Bereiche einzubringen, in denen die stoffschlüssige Verbindung, also das Verlöten der Elemente untereinander erfolgen soll.

Zur Lösung der Aufgabe sieht die Erfindung im Wesentlichen vor, dass als erstes Element ein solches verwendet wird, das Durchgangsöffnungen aufweist, dass zum Verbinden das erste Element und das zweite Element mit den zum zweiten Element hin offenen Durchgangsöffnungen aufeinandergelegt werden, dass sich geschmolzenes Lotmaterial während der Verbindung in zumindest einer der Durchgangsöffnungen bzw. in den Durchgangsöffnungen befindet und dass in der Durchgangsöffnung das geschmolzene Lotmaterial mit den Ultraschallschwingungen beaufschlagt wird.

Abweichend vom vorbekannten Verfahren ist es nicht erforderlich, dass eines der Elemente mit einem Lotmaterial umgeben ist. Vielmehr ist es ausreichend, wenn Lotmaterial ausschließlich in die Durchgangsöffnungen eingebracht wird, um die Elemente miteinander zu verbinden. Hierdurch ist insbesondere die Möglichkeit gegeben, dass bei der Verschaltung von Solarzellen verzinnte Serienverbinder nicht benötigt werden, sondern Serienverbinder, die unverzinnt sind und z. B. aus Aluminium bestehen. Somit können kostengünstige Materialien hoher Festigkeit verwendet werden, ohne dass das Risiko einer fehlerhaften Verbindung besteht. Durch die zum Einsatz gelangende Ultraschall-Löttechnik ist des Weiteren der Vorteil gegeben, dass flussmittelfrei gearbeitet werden kann.

Des Weiteren ist der Vorteil gegeben, dass das Lotmaterial gezielt im Bereich der Durchgangsöffnung und in den angrenzenden Bereichen zwischen den zu verlötenden Elementen verbleibt, da die Durchgangsöffnung quasi eine Sammelstelle für das Lotmaterial bildet und so ein unkontrolliertes Verteilen von Lotmaterial auf dem zweiten Element wie Solarzelle unterbleibt. Folglich führt das Lotmaterial nicht zu unerwünschten Abschattungen, sofern frontseitig, also auf der lichteinfallenden Seite der Solarzelle entsprechend der erfindungsgemäßen Lehre Lötverbindungen hergestellt werden. Man kann mit geringen Mengen an Lotmaterial auskommen, da sich das Lotmaterial gezielt in dem Bereich befindet, wo die stoffschlüssige Verbindung hergestellt werden soll.

Das Lotmaterial selbst wird insbesondere durch Kontakt mit dem Werkzeug, durch das die Ultraschallschwingungen appliziert werden, und/oder einer Heizeinrichtung geschmolzen. Dabei ist insbesondere vorgesehen, dass Lotmaterial einem zwischen der Heizeinrichtung und dem Werkzeug verlaufenden Spalt zugeführt und geschmolzen wird. Das geschmolzene Lot benetzt dessen verbinderseitig verlaufenden Bereich - wie Stirnfläche einer Sonotrode als das Werkzeug -, der das Lot in der Durchgangsöffnung mit Ultraschall beaufschlagt.

Die Spitze des Werkzeugs wie Sonotrode weist eine flächenmäßige Erstreckung auf, die kleiner als die der Durchgangsöffnung ist, so dass das Werkzeug während der Ultraschallbeaufschlagung in die Durchgangsöffnung eintauchen kann. Alternativ kann jedoch auch die Kontaktfläche des Werkzeugs mit dem Lot größer als die Durchgangsöffnung sein, so dass die Spitze des Werkzeugs die Durchgangsöffnung abdeckt und sich bereichsweise entlang dem Rand der Durchgangsöffnung erstreckt.

Es besteht auch die Möglichkeit, dass auf das Lotmaterial vor Auflegen des ersten Elements auf das zweite Element entsprechend der Anordnung der Durchgangsöffnungen in dem ersten Element Lotmaterial aufgebracht wird. Somit durchsetzt beim Auflegen des ersten Elements das zuvor auf das zweite Element vorzugsweise punktuell aufgebrachte Lotmaterial die Durchgangsöffnungen bzw. erstreckt sich in diesen, um sodann nach Auflegen des ersten Elements auf das zweite Element auf die einzelnen Durchgangsöffnungen das Werkzeug auszurichten und den Ultraschall zu applizieren.

Die zum Schmelzen des Lotmaterials erforderliche Wärme wird sodann über die Sonotrode übertragen, die entsprechend aufgeheizt wird.

Insbesondere ist vorgesehen, dass das Werkzeug während des stoffschlüssigen Verbindens mit einem Abschnitt in die Durchgangsöffnung eingetaucht wird. Durch diese Maßnahmen erfolgt eine optimale Einkopplung der Ultraschallschwingungen in das geschmolzene Lotmaterial sowie das zweite Element - wie z. B. Aluminiumrückseitenschicht einer Solarzelle - bei gleichzeitigem optimalen Wärmeübergang.

Vorzugsweise ist vorgesehen, dass als zweites Element ein Halbleiterbauelement wie eine Solarzelle oder ein Stromableiter (Busbar) eines Halbleiterbauelements und/oder als erstes Element ein elektrisch leitender Verbinder wie Zellenverbinder verwendet wird.

Dabei kann der Zellenverbinder abweichend von bekannten Solarzellen verschaltenden Verbindern aus einem anderen Material als Kupfer, insbesondere aus Aluminium bestehen, so dass ein kostengünstiger Verbinder zur Verfügung gestellt wird, der im hinreichenden Umfang den mechanischen Belastungen Stand hält.

Hervorzuheben ist des Weiteren, dass als zweites Element ein Halbleiterbauelement mit Vorder- und Rückseite verwendet wird, das sowohl mit der Vorder- als auch der Rückseite jeweils zumindest eines ersten Elements stoffschlüssig verbunden wird, wobei das stoffschlüssige Verbinden gleichzeitig oder nacheinander in vorzugsweise entlang einer gemeinsamen die Unter- und Oberseite lotrecht durchsetzenden Geraden verlaufenden Durchgangsöffnungen erfolgt.

Um beim Löten, also dem stoffschlüssigen Verbinden, und dem Einwirken der Ultraschallschwingungen, wobei das Werkzeug mechanisch zumindest mit dem Lotmaterial in Kontakt steht, die mechanischen Belastungen auf die Elemente, insbesondere auf das Halbleiterbauelement wie Solarzelle als zweites Element, so gering wie möglich zu halten, sieht die Erfindung vor, dass die eine Einheit bildenden aufeinander liegenden ersten und zweiten Elemente während des stoffschlüssigen Verbindens federnd in Richtung des Werkstücks und/oder das Werkstück federnd in Richtung der Einheit abgestützt bzw. gelagert werden bzw. wird.

Unabhängig hiervon besteht die Möglichkeit, dass die Einheit während des stoffschlüssigen Verbindens transportiert und das Werkzeug synchron mitbewegt wird. Eine stationäre Anordnung des Werkzeugs ist gleichfalls möglich.

Erfindungsgemäß wird ein Verfahren zum flussmittelfreien elektrischen Kontaktieren und stoffschlüssigen Verbinden vorgeschlagen, wobei eines der Elemente insbesondere eine Solarzelle und das andere Element insbesondere ein Verbinder ist. Auch ist das Verfahren anwendbar zwischen einem Zellenverbinder und z. B. einem Busbar einer Solarzelle. Dabei wird die Einheit aus den Elementen mit ultraschallbeaufschlagtem Lotmaterial verbunden.

Hierzu weist das erste Element im Bereich des die Ultraschallschwingung applizierenden Werkzeugs, das auch als Sonotrode zu bezeichnen ist, Aussparungen auf, in die das ultraschallangeregte Lotmaterial eingebarbeitet wird. Das zur Anwendung gelangende Ultraschallverfahren ermöglicht auf diese Weise eine flussmittelfreie stoffschlüssige Lötverbindung zwischen den Elementen.

Dabei wird die erforderliche Wärme, um das Lotmaterial zu schmelzen, abweichend von vorbekannten Lösungen nicht durch Erwärmen der Elemente, insbesondere einer Solarzelle, sondern über das Werkzeug - gegebenenfalls über eine diesem zugeordnete Heizung - erzeugt und auf das Lotmaterial übertragen.

Dabei ist in hervorzuhebender Ausgestaltung vorgesehen, dass zwischen der Heizeinrichtung und dem die Ultraschallschwingungen applizierenden Werkzeug ein Spalt ausgebildet wird, dem das Lotmaterial insbesondere in Drahtform zugeführt und in dem das Lotmaterial geschmolzen wird, und dass sodann das geschmolzene Lot durch Benetzen des Werkzeugs und anschließendes Einbringen in die Durchgangsöffnung das erste und zweite Element stoffschlüssig verbindet. Das Einbringen erfolgt über das Werkzeug.

Es besteht jedoch auch die Möglichkeit, bereits auf dem die Durchgangsöffnungen nicht aufweisenden zweiten Element wie Solarzelle Lotpunkte aufzubringen, deren Anordnung entsprechend der Anordnung der Durchgangsöffnungen in dem ersten Element erfolgt, so dass sich bei Auflegen des ersten Elements auf das zweite Element die Lotpunkte in den Durchgangsöffnungen befinden. Diesbezügliche Maßnahmen werden insbesondere dann gewählt, wenn eine Vorrichtung sowohl auf der Ober- als auch auf der Unterseite des zweiten Elements wie Halbleiterbauelements, insbesondere Solarzelle, mit ersten Elementen stoffschlüssig zu verbinden sind und das zweite Element eine in der Horizontalen verlaufende Ebene aufspannt.

Wird das Lotmaterial dem zwischen der Heizeinrichtung und dem Werkzeug verlaufenden Spalt zugeführt, so sollten Werkzeug und Heizeinrichtung auf eine Temperatur oberhalb der Lot-Schmelztemperatur erwärmt sein, wobei vorzugsweise die Temperatur der Heizeinrichtung unabhängig von der Temperatur des Werkzeugs eingestellt wird.

Bei der Heizeinrichtung kann es sich um einen block- oder quaderförmigen Heizkörper handeln, der werkstückseitig vorzugsweise einen den Spalt begrenzenden Vorsprung aufweist, der bevorzugterweise eine Zylinderabschnittsgeometrie aufweist.

Als Lotmaterial wird insbesondere ein solches benutzt, das auf Sn-Zn-Basis, Sn-Ag-Basis oder aus reinem Zinn besteht.

Verläuft die Längsachse des Werkzeugs vorzugsweise entlang der Normalen einer von dem zweiten Element aufgespannten Ebene, so kann auch ein hiervon abweichender Winkel gewählt werden. Entsprechend muss die Heizeinrichtung ausgerichtet werden, damit der gewünschte Spalt zur Verfügung steht.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung der Zeichnung zu entnehmenden bevorzugten Ausführungsbeispielen.

Es zeigen:
- Fig. 1: eine Seitenansicht einer Anordnung zum stoffschlüssigen Verbinden von zwei ersten Elementen mit einem zweiten Element,
- Fig. 2: einen Ausschnitt der Anordnung gem. Fig. 1 in Draufsicht,
- Fig. 3: einen weiteren Ausschnitt der Anordnung gemäß Fig. 1 vor dem stoffschlüssigen Verbinden,
- Fig. 4: eine der Fig. 3 entsprechende Darstellung während des stoffschlüssigen Verbindens,
- Fig. 5: Ausschnitte einer Sonotrode und einer dieser zugeordneten Heizeinrichtung,
- Fig. 6: eine Prinzipdarstellung des Benetzens einer Sonotrodenstirnfläche und
- Fig. 7: eine weitere Prinzipdarstellung des Benetzens einer Sonotrodenstirnfläche.

Die erfindungsgemäße Lehre wird nachstehend anhand des Verlötens von streifenförmigen Verbindungsleitern mit der Vorder- und Rückseite einer Solarzelle erläutert, ohne dass hierdurch die erfindungsgemäße Lehre eingeschränkt wird. Vielmehr kann das Verlöten auch von Verbindern untereinander oder von sonstigen Arten von elektrisch leitenden Elementen erfolgen.

Erfindungsgemäß erfolgt das Verlöten, also dass stoffschlüssige Verbinden einer Solarzelle 10, d.h. deren Oberseite 12 und deren Unterseite 14, mit Serienverbindern 16, 18 ultraschallunterstützt, ohne dass es eines Flussmittels bedarf. Hierzu wird ein Verbund, der auch als Einheit 11 zu bezeichnen ist, aus der Solarzelle 10 und den entlang der Oberseite 12 bzw. der Unterseite 14 verlaufenden Verbindern 16, 18 zwischen Abstütz- oder Fixierelementen 20, 22, 24, 26 angeordnet, zwischen denen die Einheit 11 derart positionierbar ist, dass in nachstehend beschriebener Weise das Verlöten der Verbinder 16, 18 mit der Ober- bzw. Unterseite 12, 14 der Solarzelle 10 in vorgegebenen Bereichen erfolgen kann.

Die Abstützungen 20, 22, 24, 26 bieten vorzugsweise eine federnde Fixierung der Einheit 11 derart, dass beim stoffschlüssigen Verbinden im erforderlichen Umfang ein Ausweichen der auf die Einheit 11 einwirkenden Kräfte erfolgt, so dass die mechanische Belastung minimiert wird.

Bei den Fixierelementen 20, 22, 24, 26 kann es sich auch um Transportbänder handeln, um die Einheit 11 im Ausführungsbeispiel in X-Richtung transportieren zu können.

Die Transportbänder würden dabei zum einen die Einheit 11 positionsgenau fixieren und zum anderen die Einheit 11 im erforderlichen Umfang federnd abstützen.

Federnde Abstützung bedeutet dabei, dass die Einheit 11 in Y-Richtung verstellbar ist, wobei der Federweg im Bereich von ± 1 mm liegen kann.

Unter federnder Lagerung versteht man eine Bewegung der Einheit 11 bzw. der Sonotroden 32, 34 in Y-Richtung unabhängig von der Eigenelastizität der Bauteile selbst. Die Federung kann über entsprechende Federn oder über eine eine gewünschte Federkennlinie aufweisende Abstützung erfolgen.

Zum Verlöten der Verbinder 16, 18 mit der Ober- bzw. Unterseite 12, 14 der Solarzelle 10 sind erfindungsgemäß folgende Maßnahmen vorgesehen.

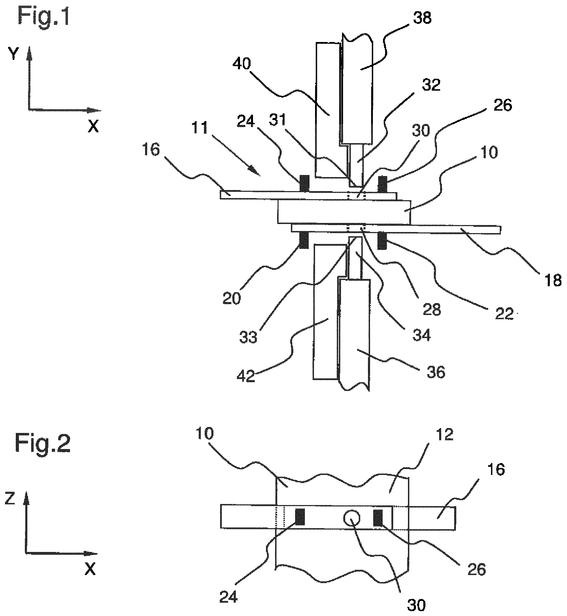

Die Verbinder 16, 18 weisen Durchgangsöffnungen 28, 30 auf, in denen bei auf die Solarzelle 10 aufgelegten Verbindern 16, 18 die unter- bzw. oberhalb der Durchgangsöffnungen 28, 30 vorhandenen Flächen der Ober- bzw. Unterseite 12, 14 der Solarzelle 10 freiliegen. Die Durchgangsöffnungen 26, 28 weisen eine geeignete Geometrie, insbesondere Kreisgeometrie oder Langlochgeometrie, aber auch Rechteckgeometrie auf. Beispielhaft ist eine Kreislochgeometrie zeichnerisch in der Fig. 2 dargestellt.

Beim Verlöten sind die Durchgangsöffnungen 28, 30 derart positioniert, dass oberhalb bzw. unterhalb dieser Stirnflächen von als Sonotroden zu bezeichnenden Werkzeugen 32, 34 zylindrischer Geometrie angeordnet sind. Die Werkzeuge 32, 34, die nächstehend als Sonotroden bezeichnet werden, sind jeweils von einem Heizmantel 36, 38 umgeben, damit die Sonotrode 32, 34 in ihrem vor dem Heizmantel 36, 38 nicht umgebenen Bereich auf eine Temperatur erwärmt werden kann, die gleich der Schmelztemperatur T_{S} von Lotmaterial ist oder oberhalb dieser liegt, mittels dessen die Verbinder 16, 18 mit der Ober- bzw. Unterseite 12, 14 der Solarzelle 10 verlötet werden.

Um das Lotmaterial in die Durchgangsöffnungen 28, 30 einzubringen, sind verschiedene Möglichkeiten gegeben. So kann der Sonotrode 32 eine Heizeinrichtung 40, 42 zugeordnet werden, die zu der Sonotrode 32, 34 derart ausgerichtet ist, dass sich ein Spalt bildet, dem das Lotmaterial in Form eines Lotdrahts zugeführt wird. Dies ist in Bezug auf die Anordnung der Sonotrode 32 möglich, die oberhalb der Einheit 11 verläuft.

Die Heizeinrichtung 40 sowie die Sonotrode 32 sind dabei auf eine Temperatur erwärmt, die oberhalb der Schmelztemperatur T_{S} des Lotdrahts liegt oder dieser entspricht. Somit schmilzt das Lotmaterial beim Einbringen des Lotdrahts in den zwischen der Heizeinrichtung 40 und der Sonotrode 32 gebildeten Spalt. Gleichzeitig wird die Sonotrode 32 in Ultraschallschwingungen erregt, so dass das Lotmaterial die Sonotrode 32 benetzen kann und zur Stirnfläche 31 fließt. Anschließend wird die benetzte Stirnfläche 31 auf die Durchgangsöffnung 30 abgesenkt und gegebenenfalls in diese eingetaucht. Somit gelangt das Lotmaterial in die Durchgangsöffnung 30.

Gleichzeitig werden die Ultraschallschwingungen auf das sich in der Durchgangsöffnung 30 befindende Lot übertragen, um so ultraschallunterstützt das Verlöten zu ermöglichen. Entsprechend wird die Sonotrode 34 mit ihrer Stirnfläche 33 zu der Durchgangsöffnung 28 verstellt, um sodann bei in der Durchgangsöffnung 28 vorhandenem Lotmaterial das stoffschlüssige Verbinden durch Ultraschallunterstützung durchzuführen.

Im Ausführungsbeispiel weist die Stirnfläche 31 der Sonotrode einen Querschnitt auf, der kleiner als der der Durchgangsöffnung 30 ist, so dass die Sonotrode 32 mit ihrer Spitze, also ihrer Stirnfläche 31, in die Durchgangsöffnung 30 eintauchen kann. Dies ist jedoch kein zwingendes Merkmal.

Entsprechend kann ein stoffschlüssiges Verbinden des Verbinders 18 mit der Unterseite 10 der Solarzelle 14 erfolgen. In diesem Fall können nach einer Alternative zuvor auf der Unterseite 14 Lötpunkte in einem Abstand aufgebracht sein, der dem Abstand der Durchgangsöffnungen 28 in dem Verbinder 18 entspricht, so dass beim Positionieren des Verbinders 18 auf der Unterseite 14 der Solarzelle 10 die Lotpunkte die Durchgangsöffnungen 28 durchsetzen. Es besteht aber auch die Möglichkeit, die Stirnfläche 33 der Sonotrode 34, die parallel - entsprechend der Stirnfläche 31 der Sonotrode 32 - zu den von der Solarzelle 10 bzw. den Verbindern 16, 18 aufgespannten Ebenen verläuft, zuvor mit Lotmaterial zu benetzen und sodann den Verbinder 18 mit der Solarzelle 10 durch Einbringen des Lotmaterials in die Durchgangsöffnung 28 bzw. Eintauchen des Spitzenbereichs der Sonotrode 34 in die Durchgangsöffnung 28 stoffschlüssig miteinander zu verbinden.

Es besteht jedoch auch die Möglichkeit, in die Durchgangsöffnungen 28 des Verbinders 18 zuvor Lotmaterial einzubringen, das sodann bei Einwirken der auf zumindest die Schmelztemperatur erhitzten Sonotrode 34 in den Durchgangsöffnungen 28 geschmolzen und somit die stoffschlüssige Verbindung hergestellt werden kann.

Die Sonotroden 32, 34 können über unabhängige Linearantriebe an die Durchgangsöffnungen 28, 30 herangefahren werden.

Zum Ausrichten der Durchgangsöffnungen 28, 30 auf die Sonotroden 32, 34 wird die Einheit 11 in X-Richtung transportiert. Dies kann mit den zuvor angesprochenen Transportbändern oder gleichwirkenden Mitteln erfolgen.

Ist die Durchgangsöffnung 30 auf die Sonotrode 32 ausgerichtet, so wird diese abgesenkt. Dabei kommt es zu einer flussmittelfreien Benetzung in der Grenzfläche zwischen dem Verbinder 16 und der Oberseite 12 der Solarzelle 10. Sodann wird die Sonotrode 32 zurückgefahren und das Lotmaterial erstarrt in der Durchgangsöffnung 30. Entsprechend erfolgt ein Verlöten des Verbinders 18 mit der Unterseite 14 der Solarzelle 10.

Das stoffschlüssige Verbinden der Verbinder 16, 18 mit der Solarzelle 10 kann auch gleichzeitig dann erfolgen, wenn jeder Sonotrode 32, 34 gleichzeitig eine Durchgangsöffnung 28, 30 zugeordnet ist, wie dies dem Ausführungsbeispiel zu entnehmen ist. Insbesondere ist dabei vorgesehen, dass die Längsachsen der Sonotroden 28, 30 entlang einer gemeinsamen Geraden verlaufen, die senkrecht zu der von der Solarzelle 10 aufgespannten Ebene verläuft, also entlang einer gemeinsamen Normalen.

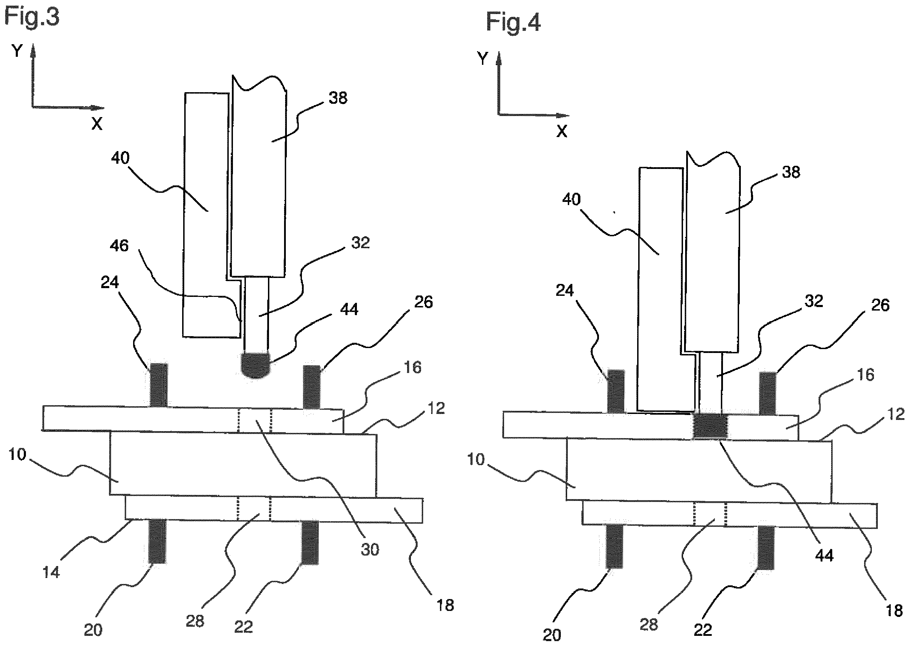

Der Lötvorgang wird noch einmal in den Fig. 3 und 4 detailliert dargestellt, und zwar im Zusammenhang mit dem stoffschlüssigen Verbinden des Verbinders 16 mit der Oberseite 12 der Solarzelle 10.

In der Fig. 3 befindet sich die Sonotrode 32 mit der dieser zugeordneten und einen Spalt 46 zu der Sonotrode 32 begrenzenden Heizeinrichtung 40 oberhalb der Durchgangsöffnung 30. Über den Spalt 46 fließt Lotmaterial entlang der Sonotrode 32 zu dessen Spitze, also Stirnfläche 31, wobei die Sonotrode 32 ultraschallerregt ist. Sodann wird die Sonotrode 32 mit der Heizeinrichtung 40 derart abgesenkt, dass das im Stirnflächenbereich befindende Lotmaterial 44 in die Durchgangsöffnung 30 eindringt, um ultraschallunterstützt den Verbinder 16 und die Oberseite 12 der Solarzelle 10 zu benetzen. Anschließend wird die Sonotrode 32 mit der Heizeinrichtung 40 in Y-Richtung wieder abgehoben.

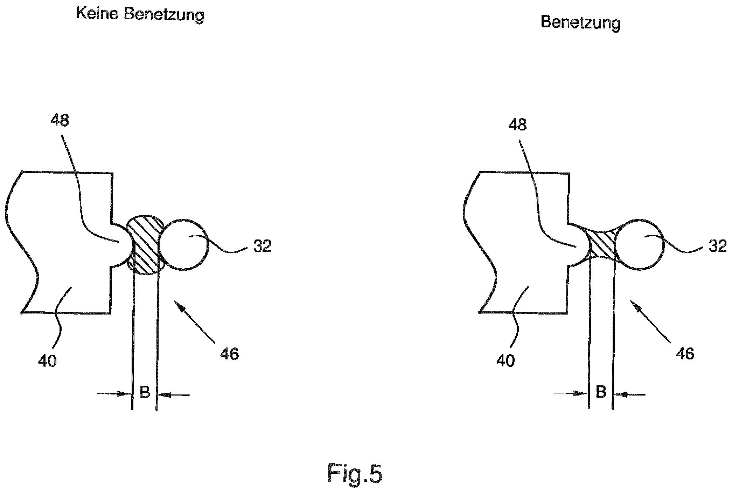

Der Fig. 5 ist ein Ausschnitt der Sonotrode 32 und der zugeordneten Heizeinrichtung 40 zu entnehmen, und zwar im Bereich des zwischen diesen verlaufenden Spalts 46, in dem das zu schmelzende Lotmaterial in Form eines Lotdrahts eingebracht wird.

Die Fig. 5 verdeutlicht, dass die Breite B des Spalts 46, also der lichte Abstand zwischen der Sonotrode 32 und dem von der Heizeinrichtung 40 in Richtung der Sonotrode 32 vorspringenden Vorsprung 48 derart gewählt sein sollte, dass dieser vorzugsweise zwischen ½ D und D mit D = Durchmesser des Lotdrahts entspricht. Die Breite B erstreckt sich in Längsrichtung des Verbinders 16 und kann über die Höhe konstant sein oder sich in Richtung des Verbinders 16 konisch erweitern.

Sowohl der Heizkörper 40 als auch die Sonotrode 32 werden auf eine Temperatur eingestellt, die insbesondere oberhalb der Schmelztemperatur des Lotdrahts liegt. Vorzugsweise wird Lotmaterial benutzt, dass im Bereich zwischen 100 °C und 350 °C schmilzt, gleichwenn die Temperatur zwischen 80 °C und 600 °C liegen kann. Die Temperatureinstellung des Heizkörpers 40 im Bereich seines Vorsprungs 48 sollte dabei unabhängig von der Einstellung der Temperatur der Sonotrode 32 erfolgen.

Erfindungsgemäß wird der Lotdraht dem Spalt 46 zugeführt. Dabei schmilzt der Lotdraht. Ungeachtet der hohen Oberflächenspannung erfolgt ein Benetzen der Begrenzung des Spalts 46 (siehe rechte Darstellung in Fig. 5) dann, wenn die Sonotrode 32 in Ultraschallschwingung erregt ist. Dies hat zur Folge, dass das geschmolzene Lot durch den Spalt 46 entlang der Sonotrode 32 zu dessen Spitze, also Stirnfläche 31 fließen kann.

Der linken Darstellung in Fig. 5 ist das geschmolzene Lot bei nicht in Schwingungen versetzter Sonotrode 32 zu entnehmen.

Die Sonotrode 32, 34 kann des Weiteren beim Übertragen der Ultraschallschwingung auf das Lotmaterial oszillierende Bewegung senkrecht zu deren Längsachse ausüben.

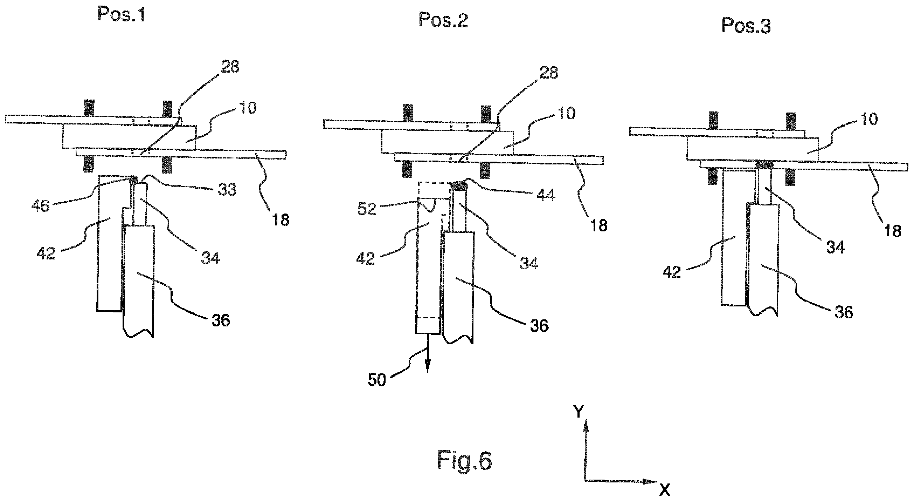

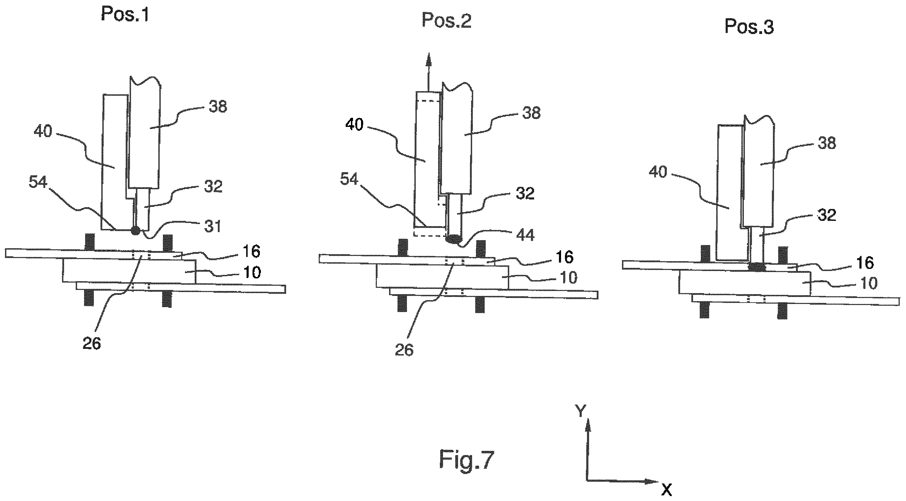

Insbesondere erfolgt das Aufschmelzen des Lotmaterials in dem zwischen der Sonotrode 32, 34 und der zugeordneten Heizung 40, 42 verlaufenden Spalt unmittelbar im Bereich der jeweiligen Stirnfläche 32, 34, so dass diese mit dem Lotmaterial benetzt werden kann. Dies soll anhand der Fig. 6 und 7 erläutert werden, in denen entsprechend den Fig. 1 - 5 für gleiche Elemente gleiche Bezugszeichen verwendet werden.

Durch die Fig. 6 soll das Benetzen der unterhalb des Verbinders 18 und der Solarzelle 10 angeordneten Sonotrode 34 mit der zugeordneten Heizung 42 erläutert werden. In Pos. 1 ist die Heizung 42 derart zu der Stirnfläche 33 der Sonotrode 34 ausgerichtet, dass dem zwischen der Heizung 42 und der Sonotrode 34 verlaufenden Spalt, der sich im Bereich der Stirnfläche 33 befindet, ein Lotdraht zugeführt wird, so dass nach Aufschmelzen des Lotmaterials die Stirnfläche 33 mit Lot benetzt wird. Sodann wird die Heizung 42 entsprechend der Phantomdarstellung in Pos. 2 in Richtung des Pfeils 50 relativ zu der Sonotrode 34 verstellt, so dass infolgedessen die Stirnfläche 33 mit dem Lotmaterial 44 beabstandet zur verbinderseitig verlaufenden Stirnfläche 52 der Heizung 42 verläuft. Sodann wird die Sonotrode 34 zusammen mit der Heizung 42 in Richtung des Verbinders 10 verstellt, wie sich aus der Pos. 3 ergibt. Dabei gelangt das Lotmaterial 44 in die Durchgangsöffnung 28, wobei gegebenenfalls die Sonotrode 34 mit ihrem Stirnbereich 33 in die Durchgangsöffnung 28 eintaucht. Durch diese Maßnahmen ist das stoffschlüssige Verbinden zwischen dem Verbinder 18 und der Solarzelle 10 realisierbar.

Entsprechend ist in Fig. 7 das stoffschlüssige Verbinden zwischen dem Verbinder 16 und der Solarzelle 10 rein schematisch dargestellt. In der Pos. 1 befindet sich die verbinderseitig verlaufende Stirnfläche 54 der Heizung 40 vorzugsweise fluchtend oder in etwa fluchtend zur Stirnfläche 31 der Sonotrode 32. In den zwischen der Heizung 40 und der Sonotrode 32 gebildeten Spalt, und zwar im Bereich der Stirnfläche 31 und damit der Stirnfläche 54, wird vorzugsweise ein Lotdraht eingeführt, so dass Lot schmilzt mit der Folge, dass die Stirnfläche 31 mit Lotmaterial benetzt wird, wie Pos. 2 verdeutlicht.

Der auf der Stirnfläche 31 vorhandene Lotpunkt 44 wird sodann in die Durchgangsöffnung 21 durch Absenken der Sonotrode 32 in Richtung der Durchgangsöffnung 26 in diese eingebracht, um den Verbinder 16 mit der Solarzelle 10 stoffschlüssig zu verbinden. Zuvor erfolgt eine Relativbewegung zwischen der Sonotrode 32 und der Heizung 40 derart, dass die Stirnfläche 54 der Heizung 40 zurückversetzt zur Stirnfläche 31 der Sonotrode 32 verläuft, wie die Pos. 2 mit den Phantomlinien verdeutlicht.

Zu den Durchgangsöffnungen 28, 30 ist anzumerken, dass diese bei einer Kreisgeometrie einen Durchmesser zwischen 0,01 mm bis 10 mm und bei einer Rechteckgeometrie Schenkellängen zwischen 1 mm und 150 mm aufweisen sollten.

Das Volumen an Lotmaterial, das in eine Durchgangsöffnung 28, 30 einbringbar ist, kann zwischen 0,01 mm³ und 100 mm³ liegen, bevorzugterweise jedoch zwischen 0,05 mm³ und 0,25 mm³.

## Patentansprüche

1. Verfahren zum stoffschlüssigen Verbinden eines ersten Elements (16, 18), wie ersten Verbinder, mit einem zweiten Element (10), wie zweiten Verbinder und/oder Halbleiterbauelement wie Solarzelle, wobei die Elemente während des Verbindens aufeinander liegen und mittels Lotmaterial verbunden werden, das während des Verbindens mittels eines Werkzeugs (32, 34), wie Sonotrode, mit Ultraschallschwingungen beaufschlagt wird, wobei das Werkzeug während des Verbindens eine Temperatur Tw mit insbesondere T_{W} ≥ T_{S} mit T_{S} = Schmelztemperatur des Lotmaterials aufweist,
**dadurch gekennzeichnet,**
**dass** als erstes Element (16, 18) ein solches verwendet wird, das Durchgangsöffnungen (28, 30) aufweist,
**dass** zum Verbinden das erste Element und das zweite Element (10) mit zum zweiten Element hin offenen Durchgangsöffnungen aufeinander gelegt werden, und
**dass** sich geschmolzenes Lotmaterial während des Verbindens in zumindest einer der Durchgangsöffnungen befindet und in der Durchgangsöffnung das geschmolzene Lotmaterial mit den Ultraschallschwingungen beaufschlagt wird.

2. Verfahren nach Anspruch 1,
**dadurch gekennzeichnet,**
**dass** das Lotmaterial durch Kontakt mit dem Werkzeug (32, 34) und/oder einer Heizeinrichtung (40, 42) geschmolzen wird.

3. Verfahren nach zumindest Anspruch 2,
**dadurch gekennzeichnet,**
**dass** das Lotmaterial einem zwischen der Heizeinrichtung (40) und dem Werkzeug (32) verlaufenden Spalt (46) zugeführt und geschmolzen wird und durch den Spalt entlang des Werkzeugs in Richtung verbinderseitig verlaufenden Bereichs des Werkzeugs, wie Stirnfläche (31) einer Sonotrode (32) als das Werkzeug, fließt.

4. Verfahren nach zumindest einen der vorherigen Ansprüche,
**dadurch gekennzeichnet,**
**dass** vor Auflegen des ersten Elements (16, 18) auf das zweite Element (10) entsprechend der Anordnung der Durchgangsöffnungen (28, 30) auf dem ersten Element Lotmaterial aufgebracht wird.

5. Verfahren nach zumindest einen der vorherigen Ansprüche,
**dadurch gekennzeichnet,**
**dass** das Werkzeug (32, 34) während des stoffschlüssigen Verbindens mit einem Abschnitt bzw. dessen elementseitiger Stirnfläche (31, 33) in die Durchgangsöffnung (28, 30) eingetaucht wird.

6. Verfahren nach zumindest einen der vorherigen Ansprüche,
**dadurch gekennzeichnet,**
**dass** als zweites Element ein Halbleiterbauelement, wie eine Solarzelle (10) oder ein Stromableiter (Busbar) einer Solarzelle, und als erstes Element (16, 18) ein elektrisch leitender Verbinder, wie Zellenverbinder, verwendet wird.

7. Verfahren nach zumindest einen der vorherigen Ansprüche,
**dadurch gekennzeichnet,**
**dass** als zweites Element eine Solarzelle (10) mit Vorder- und Rückseite (12, 14) verwendet wird, und dass sowohl mit der Vorder- als auch der Rückseite jeweils zumindest ein erstes Element (16, 18) stoffschlüssig verbunden wird, wobei das stoffschlüssige Verbinden gleichzeitig oder nacheinander in vorzugsweise entlang einer gemeinsamen die Unter- und Oberseite lotrecht durchsetzenden Geraden vorhandenen Durchgangsöffnungen (28, 30) erfolgt.

8. Verfahren nach zumindest einen der vorherigen Ansprüche,
**dadurch gekennzeichnet,**
**dass** die eine Einheit (11) bildenden aufeinander liegenden ersten und zweiten Elemente (10, 16, 18) während des stoffschlüssigen Verbindens federnd in Richtung des Werkstücks (32, 34) und/oder das Werkstück federnd in Richtung der Einheit abgestützt werden bzw. wird.

9. Verfahren nach zumindest einen der vorherigen Ansprüche,
**dadurch gekennzeichnet,**
**dass** die Einheit (11) während des stoffschlüssigen Verbindens transportiert und das Werkzeug (32, 34) synchron mitbewegt wird.

10. Verfahren nach zumindest einen der vorherigen Ansprüche,
**dadurch gekennzeichnet,**
**dass** als erstes Element (16, 18) ein lotfreier Verbinder, insbesondere ein aus Aluminium bestehender oder Aluminium enthaltender Verbinder, verwendet wird.

11. Verfahren nach zumindest einen der vorherigen Ansprüche,
**dadurch gekennzeichnet,**
**dass** als Lotmaterial ein Lotdraht verwendet wird, der einem zwischen einer Heizeinrichtung (40) und dem Werkzeug (32) gebildeten Spalt (46) zugeführt und geschmolzen wird.

12. Verfahren nach zumindest einen der vorherigen Ansprüche,
**dadurch gekennzeichnet,**
**dass** das Werkzeug (32, 34) und die Heizeinrichtung (40, 42) jeweils auf eine Temperatur oberhalb der Schmelztemperatur T_{S} des Lotmaterials erwärmt wird, wobei vorzugsweise die Temperatur der Heizeinrichtung unabhängig von der Temperatur des Werkzeugs eingestellt wird.

13. Verfahren nach zumindest einen der vorherigen Ansprüche,
**dadurch gekennzeichnet,**
**dass** als Lotmaterial ein solches benutzt wird, dass auf einer Sn-Zn-Basis, Sn-Ag-Basis oder aus insbesondere reinem Zinn besteht.

14. Verfahren nach zumindest einen der vorherigen Ansprüche,
**dadurch gekennzeichnet,**
**dass** das Lotmaterial unmittelbar im Bereich der Stirnfläche (31, 33) der Sonotrode (32, 34) dem zwischen dieser und der zugeordneten Heizeinrichtung (40, 42) verlaufenden Spalt (46) zugeführt wird und dass vor oder während des Verstellens der Sonotrode (32, 34) in Richtung der Durchgangsöffnung (26, 28) die Heizeinrichtung (40, 42) zu der Sonotrode (32, 34) relativ verstellt wird.

## Claims

1. A method for the cohesive connection of a first element (16, 18) such as the first connector to a second element (10) such as the second connector and/or semiconductor component such as a solar cell, whereby the elements lie on one another during the connecting and are connected by solder material that is loaded during the connecting by a tool (32, 34) such as a sonotrode with ultrasonic oscillations, whereby the tool has a temperature T_{W} during the connection with in particular T_{W} ≥ T_{S} with T_{S} = the melting temperature of the solder material,
**characterized in that**
an element is provided as the first element (16, 18) that comprises passage openings (28, 30),
that for the connection, the first element and the second element (10) are placed on one another with the passage openings open to the second element,
and
that molten solder material is present during the connecting in at least one of the passage openings , and the molten solder material in the passage opening is loaded with the ultrasonic oscillations.

2. The method according to claim 1,
**characterized in that**
the solder material is melted by contact with the tool (32, 34) and/or with a heating device (40, 42).

3. The method according to at least claim 2,
**characterized in that**
the solder material is supplied to a slot (46) running between the heating device (40) and the tool (32), is melted and flows through the slot along the tool in the direction of the area of the tool running on the connector side such as the front surface (31) of a sonotrode (32) as the tool.

4. The method according to at least one of the previous claims,
**characterized in that**
prior to the placing of the first element (16, 18) onto the second element (10) solder material is applied on the first element in accordance with the arrangement of the passage openings (28, 30).

5. The method according to at least one of the previous claims,
**characterized in that**
the tool (32, 34) is introduced into the passage opening (28, 30) during the cohesive connection with a section or its front surface (31, 33) on its element side.

6. The method according to at least one of the previous claims,
**characterized in that**
a semiconductor component such as a solar cell (10) or a current derivation (bus bar) of a solar cell is used as the second element and an electrically conductive connector such as a cell connector is used as the first element (16, 18).

7. The method according to at least one of the previous claims,
**characterized in that**
a solar cell (10) with a front and a back side (12, 14) is used as the second element, and that at least one first element (16, 18) is cohesively connected to the front- as well as to the back side, whereby the cohesive connecting takes place simultaneously or in series in passage openings (28, 30) preferably along a common straight line passing vertically through the lower side and the top side.

8. The method according to at least one of the previous claims,
**characterized in that**
the first and second elements (10, 16, 18) that rest on one another and form a unit (11) are resiliently supported during the cohesive connection in the direction of the tool (32, 34) and/or the tool is resiliently supported in the direction of the unit.

9. The method according to at least one of the previous claims,
**characterized in that**
the unit (11) is transported during the cohesive connection and that the tool (32, 34) is synchronously moved with it.

10. The method according to at least one of the previous claims,
**characterized in that**
a connector free of solder, in particular a connector consisting of aluminum or containing aluminum is used as the first element (16, 18).

11. The method according to at least one of the previous claims,
**characterized in that**
a soldering wire is used as solder material that is supplied to a slot (46) formed between a heating device (40) and the tool (32) and is melted.

12. The method according to at least one of the previous claims,
**characterized in that**
the tool (32, 34) and the heating device (40, 42) are heated to a temperature above the melting temperature T_{S} of the solder material, whereby the temperature of the heating device is preferably adjusted independently of the temperature of the tool.

13. The method according to at least one of the previous claims,
**characterized in that**
the solder material used is one based on Sn-Zn, on Sn-Ag or in particular consists of pure tin.

14. The method according to at least one of the previous claims,
**characterized in that**
the solder material is supplied directly in the area of the front surface (31, 33) of the sonotrode (32, 34) to the slot (46) between the latter and the associated heating device (40, 42), and that before or during the moving of the sonotrode (32, 34) in the direction of the passage opening (26, 28) the heating device (40, 42) is moved relative to the sonotrode (32, 34).

## Revendications

1. Procédé pour raccorder par liaison de matière un premier élément (16, 18), tel qu'un premier connecteur, avec un deuxième élément (10), tel qu'un deuxième connecteur et/ou un composant semi-conducteur tel qu'une cellule solaire, procédé dans lequel pendant le raccordement les éléments reposent l'un sur l'autre et sont raccordés à l'aide d'un matériau de brasage qui est soumis pendant le raccordement à des vibrations ultrasonores par un outil (32, 34), tel qu'une sonotrode, sachant que pendant le raccordement l'outil présente une température T_{W} telle qu'en particulier T_{W} ≥ T_{S}, où T_{S} est la température de fusion du matériau de brasage,
**caractérisé en ce**
**qu'**en tant que premier élément (16, 18) est utilisé un élément présentant des orifices de passage (28, 30),
**que** pour le raccordement, le premier élément et le deuxième élément (10) sont placés l'un sur l'autre avec des orifices de passage ouverts en direction du deuxième élément,
et
**que** pendant le raccordement, le matériau de brasage fondu se trouve dans au moins un des orifices de passage, et ledit matériau de brasage fondu est soumis dans l'orifice de passage à des vibrations ultrasonores.

2. Procédé selon la revendication 1,
**caractérisé en ce**
**que** le matériau de brasage est fondu par contact avec l'outil (32, 34) et/ou avec un dispositif chauffant (40, 42).

3. Procédé selon au moins la revendication 2,
**caractérisé en ce**
**que** le matériau de brasage est introduit et fondu dans un interstice (46) s'étendant entre le dispositif chauffant (40) et l'outil (32), et s'écoule à travers l'interstice le long de l'outil en direction de la zone de l'outil s'étendant du côté du connecteur, telle que la face frontale (31) d'une sonotrode (32) servant d'outil.

4. Procédé selon au moins une des revendications précédentes,
**caractérisé en ce**
**qu'**avant de poser le premier élément (16, 18) sur le deuxième élément (10), du matériau de brasage est appliqué sur le premier élément conformément à l'agencement des orifices de passage (28, 30).

5. Procédé selon au moins une des revendications précédentes,
**caractérisé en ce**
**que** pendant le raccordement par liaison de matière, une partie de l'outil (32, 34) ou sa face frontale (31, 33) du côté de l'élément est plongée dans l'orifice de passage (28, 30).

6. Procédé selon au moins une des revendications précédentes,
**caractérisé en ce**
**qu'**en tant que deuxième élément est utilisé un composant semi-conducteur, tel qu'une cellule solaire (10) ou un collecteur de courant (barre omnibus) d'une cellule solaire, et qu'en tant que premier élément (16, 18) est utilisé un connecteur électroconducteur, tel qu'un connecteur intercellulaire.

7. Procédé selon au moins une des revendications précédentes,
**caractérisé en ce**
**qu'**est utilisée en tant que deuxième élément une cellule solaire (10) avec face avant et face arrière (12, 14), et que la face avant ainsi que la face arrière sont respectivement reliées par liaison de matière à au moins un premier élément (16, 18), sachant que le raccordement par liaison de matière est effectué simultanément ou successivement de préférence le long d'une droite commune traversant verticalement la face inférieure et la face supérieure des orifices de passage (28, 30) présents.

8. Procédé selon au moins une des revendications précédentes,
**caractérisé en ce**
**que** pendant le raccordement par liaison de matière, le premier et le deuxième éléments (10, 16, 18) superposés formant une unité (11) sont soutenus de manière élastique en direction de l'outil (32, 34) et/ou que l'outil est soutenu de manière élastique en direction de l'unité.

9. Procédé selon au moins une des revendications précédentes,
**caractérisé en ce**
**que** pendant le raccordement par liaison de matière, l'unité (11) est transportée et l'outil (32, 34) est déplacé avec elle en synchronisme.

10. Procédé selon au moins une des revendications précédentes,
**caractérisé en ce**
**qu'**en tant que premier élément (16, 18) est utilisé un connecteur sans brasage, en particulier un connecteur constitué d'aluminium ou contenant de l'aluminium.

11. Procédé selon au moins une des revendications précédentes,
**caractérisé en ce**
**qu'**en tant que matériau de brasage est utilisé un fil d'apport qui est introduit et fondu dans un interstice (46) formé entre un dispositif chauffant (40) et l'outil (32).

12. Procédé selon au moins une des revendications précédentes,
**caractérisé en ce**
**que** l'outil (32, 34) et le dispositif chauffant (40, 42) sont respectivement chauffés à une température supérieure à la température de fusion T_{S} du matériau de brasage, sachant que de préférence la température du dispositif chauffant est réglée indépendamment de la température de l'outil.

13. Procédé selon au moins une des revendications précédentes,
**caractérisé en ce**
**qu'**est utilisé un matériau de brasage constitué d'une base de Sn-Zn, d'une base de Sn-Ag ou en particulier d'étain pur.

14. Procédé selon au moins une des revendications précédentes,
**caractérisé en ce e**
que dans la zone de la face frontale (31, 33) de la sonotrode (32, 34), le matériau de brasage est introduit directement dans l'interstice (46) s'étendant entre ladite sonotrode et le dispositif chauffant (40, 42) associé, et qu'avant ou pendant le déplacement de la sonotrode (32, 34) en direction de l'orifice de passage (26, 28), le dispositif chauffant (40, 42) est déplacé par rapport à la sonotrode (32, 34).
